# EUROPEAN PATENT SPECIFICATION

(11) **EP 3 901 778 B1**
(45) Date of publication and mention of the grant of the patent: **30.08.2023**
(21) Application number: 20216297.0
(22) Date of filing: 22.12.2020
(51) Int. Cl.: G06F 13/16, G11C 5/06, G11C 7/02, G11C 7/04, G11C 7/10, H01L 27/06

(54) **STACKED MEMORY DEVICE WITH END TO END DATA BUS INVERSION**
GESTAPELTE SPEICHERVORRICHTUNG MIT END-TO-END-DATENBUSINVERSION
DISPOSITIF DE MÉMOIRE EMPILÉE À INVERSION DE BUS DE DONNÉES DE BOUT EN BOUT

(30) Priority: 21.04.2020 US 202016854280
(43) Date of publication of application: 27.10.2021
(73) Proprietor: INTEL Corporation, Santa Clara, CA 95054 (US)
(72) Inventor: LANKA, Narasimha, Santa Clara, CA 95054 (US); BAINS, Kuljit, Santa Clara, CA 95054 (US); SESHAN, Lakshmipriya, Santa Clara, CA 95054 (US)
(74) Representative: Rummler, Felix

(56) References cited:
- US-A1- 2015 229 325
- US-A1- 2016 162 434
- US-A1- 2017 162 237
- US-A1- 2018 047 432

## Description

### BACKGROUND

Standards for a high bandwidth memory (HBM) dynamic random access memory (DRAM) interface are published by JEDEC (www.jedec.org). Updates to these standards include HBM2 and HMB2E. HBM technology provides higher bandwidth at lower power consumption as compared to some other memory technologies. HBM technology may include stacks of memory dice and a much wider memory bus as compared to some other memory technologies.

US2015/0229325A1 describes a data bus that is split into partitions and encoding is independently applied to data transmitted over each bus partition to improve power and/or throughput efficiency. The encoding can be data bus inversion or any other suitable type of encoding. An encoding indicator symbol transmitted in conjunction with the data indicates which bus partition is encoded, if any. In some implementations, encoding is selectively applied to each bus partition during each data transfer cycle of a parallel data bus. The encoding indicator symbol may be a multi-level signal where each level of the multi-level signal represents at least two bits of information indicative of, for a corresponding bus partition, whether encoding is applied to the data to be transmitted over the bus partition. The encoding indicator symbol can be transmitted over a single, dedicated bus line.

US2016/0162434A1 describes dynamic bus inversion for programmable levels of aeration of ones and zeros. A transmitting device identifies a number and/or ratio of ones and zeros in a non-inverted version of a signal to be transferred and a number and/or ratio of ones and zeros in an inverted version of the signal. The transmitting device can calculate whether a difference of ones and zeros in the non-inverted signal or a difference of ones and zeros in the inverted signal provides a calculated average ratio of ones to zeros closer to a target ratio. The transmitting device sends the signal that achieves the calculated average ratio closer to the target ratio.

US2017/0162237A1 describes a semiconductor apparatus that includes a plurality of dies. Any one of the dies may be set to a first rank and another of the dies may be set to a second rank. One or more of the first and second ranks may be configured to output any one of an even-numbered byte or an odd-numbered byte through an input/output stage at a timing earlier than the other one, according to a read command.

US2018/0047432A1 describes apparatuses and methods of data communication between semiconductor chips. An apparatus includes a firs semiconductor chip and a second semiconductor chip that are stacked with each other via through substrate vias provided in one of the first semiconductor chip and the second semiconductor chip. The first semiconductor chip and the second semiconductor chip communicate with each other by use of a data bus inversion of data that have been encoded using a DBI algorithm.

### SUMMARY OF INVENTION

The present invention is defined in the independent claims. The dependent claims recite selected optional features.

### BRIEF DESCRIPTION OF THE DRAWINGS

The material described herein is illustrated by way of example and not by way of limitation in the accompanying figures. For simplicity and clarity of illustration, elements illustrated in the figures are not necessarily drawn to scale. For example, the dimensions of some elements may be exaggerated relative to other elements for clarity. Further, where considered appropriate, reference labels have been repeated among the figures to indicate corresponding or analogous elements. In the figures:
FIG. 1 is a block diagram of an example of a memory apparatus according to an embodiment;
FIG. 2 is a block diagram of an example of an electronic apparatus according to an embodiment;
FIGs. 3A and 3B are bar graphs of examples of number of lanes switching versus total occurrences according to embodiments;
FIG. 4 is an illustrative timing diagram of an example of data bus inversion according to an embodiment;
FIG. 5 is an illustrative timing diagram of another example of data bus inversion with internal data bus inversion according to an embodiment;
FIG. 6 is a perspective, block diagram view of an example of a memory stack device according to an embodiment;
FIGs. 7A to 7B are front view and top view block diagrams, respectively, of an example of an electronic apparatus according to an embodiment;
FIG. 8 is a block diagram of another example of a memory apparatus according to an embodiment;
FIG. 9 is a block diagram of an example of a computing system according to an embodiment.

### DETAILED DESCRIPTION

The material disclosed herein may be implemented in hardware, firmware, software, or any combination thereof. The material disclosed herein may also be implemented as instructions stored on a machine-readable medium, which may be read and executed by one or more processors. A machine-readable medium may include any medium and/or mechanism for storing or transmitting information in a form readable by a machine (e.g., a computing device). For example, a machine-readable medium may include read only memory (ROM); random access memory (RAM); magnetic disk storage media; optical storage media; flash memory devices; electrical, optical, acoustical or other forms of propagated signals (e.g., carrier waves, infrared signals, digital signals, etc.), and others.

Various embodiments described herein may include a memory component and/or an interface to a memory component. Such memory components may include volatile and/or nonvolatile (NV) memory. Volatile memory may be a storage medium that requires power to maintain the state of data stored by the medium. Non-limiting examples of volatile memory may include various types of RAM, such as DRAM or static RAM (SRAM). One particular type of DRAM that may be used in a memory module is synchronous dynamic RAM (SDRAM). In particular embodiments, DRAM of a memory component may comply with a standard promulgated by Joint Electron Device Engineering Council (JEDEC), such as JESD79F for double data rate (DDR) SDRAM, JESD79-2F for DDR2 SDRAM, JESD79-3F for DDR3 SDRAM, JESD79-4A for DDR4 SDRAM, JESD209 for Low Power DDR (LPDDR), JESD209-2 for LPDDR2, JESD209-3 for LPDDR3, and JESD209-4 for LPDDR4 (these standards are available at jedec.org). Such standards (and similar standards) may be referred to as DDR-based standards and communication interfaces of the storage devices that implement such standards may be referred to as DDR-based interfaces.

NV memory (NVM) may be a storage medium that does not require power to maintain the state of data stored by the medium. In one embodiment, the memory device may include a block addressable memory device, such as those based on NAND or NOR technologies. A memory device may also include future generation nonvolatile devices, such as a three dimensional (3D) crosspoint memory device, or other byte addressable write-in-place nonvolatile memory devices. In one embodiment, the memory device may be or may include memory devices that use chalcogenide glass, multi-threshold level NAND flash memory, NOR flash memory, single or multi-level Phase Change Memory (PCM), a resistive memory, nanowire memory, ferroelectric transistor RAM (FeTRAM), anti-ferroelectric memory, magnetoresistive RAM (MRAM) memory that incorporates memristor technology, resistive memory including the metal oxide base, the oxygen vacancy base and the conductive bridge RAM (CB-RAM), or spin transfer torque (STT)-MRAM, a spintronic magnetic junction memory based device, a magnetic tunneling junction (MTJ) based device, a DW (Domain Wall) and SOT (Spin Orbit Transfer) based device, a thyristor based memory device, or a combination of any of the above, or other memory. The memory device may refer to the die itself and/or to a packaged memory product. In particular embodiments, a memory component with non-volatile memory may comply with one or more standards promulgated by the JEDEC, such as JESD218, JESD219, JESD220-1, JESD223B, JESD223-1, or other suitable standard (the JEDEC standards cited herein are available at jedec.org).

With reference to FIG. a memory apparatus 10 includes a memory core 11, a plurality of through-silicon vias (TSVs) 12, and data bus inversion (DBI) logic 13 coupled between the memory core 11 and the TSVs 12. The DBI logic 13 is configured to encode and decode a data signal on a signal path through the TSVs 12 in accordance with a data bus inversion of the data signal. In some embodiments, the DBI logic 13 may be configured to extend the data bus inversion of the data signal from a memory controller to a physical layer of the memory apparatus, and/or to extend the data bus inversion from a memory controller to the memory core 11.

In some embodiments, the DBI logic 13 may be further configured to arrange bits of the data signal non-sequentially among the TSVs 12 in accordance with the data bus inversion of the data signal. For example, the DBI logic 13 may include a multi-entry first-in-first-out (FIFO) buffer to arrange the bits of the data signal non-sequentially (e.g., a two entry FIFO). The memory core 11 is associated with a plurality of ranks, and the DBI logic 13 is further configured to keep track of previous read cycles for consecutive read operations to different ranks of the plurality of ranks, and to keep track of data sent from an inactive rank of the plurality of ranks.

Embodiments of each of the above memory core 11, TSVs 12, DBI logic 13, and other system components may be implemented with any suitable memory technology, including hardware, software, or any suitable combination thereof. For example, hardware implementations may include configurable logic such as, for example, programmable logic arrays (PLAs), field programmable gate arrays (FPGAs), complex programmable logic devices (CPLDs), or fixed-functionality logic hardware using circuit technology such as, for example, application specific integrated circuit (ASIC), complementary metal oxide semiconductor (CMOS) or transistor-transistor logic (TTL) technology, or any combination thereof.

In some embodiments, the memory components may be located in, or co-located with, various other components, including a controller (e.g., on a same die). Embodiments of a suitable controller may include a general purpose controller, a special purpose controller, a memory controller, a storage controller, a micro-controller, a general purpose processor, a special purpose processor, a central processor unit (CPU), an execution unit, etc. Alternatively, or additionally, all or portions of the controller may be implemented in one or more modules as a set of logic instructions stored in a machine- or computer-readable storage medium such as random access memory (RAM), read only memory (ROM), programmable ROM (PROM), firmware, flash memory, etc., to be executed by a processor or computing device. For example, computer program code to carry out the operations of the components may be written in any combination of one or more operating system (OS) applicable/appropriate programming languages, including an object-oriented programming language such as PYTHON, PERL, JAVA, SMALLTALK, C++, C# or the like and conventional procedural programming languages, such as the "C" programming language or similar programming languages.

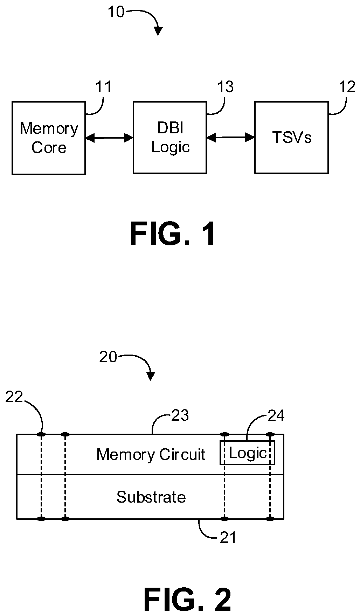

Turning now to FIG. 2, an embodiment of an electronic apparatus 20 includes a silicon substrate 21, a plurality of vias 22 disposed completely through the silicon substrate 21 (e.g., TSVs), and a memory circuit 23 coupled to the silicon substrate 21 and the plurality of vias 22. The memory circuit 23 includes logic 24 to encode and decode a data signal on a signal path through the plurality of vias 22 in accordance with a data bus inversion of the data signal. In some embodiments, the logic 24 may be configured to extend the data bus inversion of the data signal from a memory controller to a physical layer of the memory circuit 23, and/or to extend the data bus inversion from a memory controller to a memory core of the memory circuit 23.

In some embodiments, the logic 24 may be further configured to arrange bits of the data signal non-sequentially among the plurality of vias 22 in accordance with the data bus inversion of the data signal. For example, the logic 24 may include a multi-entry FIFO buffer to arrange the bits of the data signal non-sequentially (e.g. a two entry FIFO). The memory circuit 23 is associated with a plurality of ranks, and the logic 24 is further configured to keep track of previous read cycles for consecutive read operations to different ranks of the plurality of ranks, and to keep track of data sent from an inactive rank of the plurality of ranks.

In any of the embodiments herein, the memory circuit 23 may comprise RAM, such as DRAM. In some memory devices, multiple embodiments of the apparatus 20 may be coupled to each other utilizing a plurality of through-silicon-vias (TSVs), as may be utilized in various HBM technologies, for example. Embodiments of the silicon substrate 21, vias 22, memory circuit 23, and logic 24 may be fabricated utilizing any suitable silicon/memory fabrication techniques.

For example, the electronic apparatus 10 may be implemented on a semiconductor apparatus which includes the silicon substrate 21, with the memory circuit 23 coupled to the silicon substrate 21. In some embodiments, the memory circuit 23 may be at least partly implemented in one or more of memory components on the silicon substrate 21. For example, the memory circuit 23 may include a transistor array and/or other integrated circuit components coupled to the silicon substrate 21 with transistor channel regions that are positioned within the silicon substrate 21. The interface between the memory circuit 23 and the silicon substrate 21may not be an abrupt junction. The memory circuit 23 may also be considered to include an epitaxial layer that is grown on an initial wafer of the silicon substrate 21.

Some embodiments may advantageously provide technology for end to end DBI to enable power savings in stacked memory devices. DBI technology may be utilized used in various parallel input/output (IO) circuits to limit the count of simultaneous lane switching to reduce power and simultaneous switching operation (SSO) noise. In stacked memory devices, such as HBM devices, DBI encoding and decoding may conventionally be performed in a logic base die while the TSV path to the memory cores is conventionally an un-encoded transmission. A problem with the conventional arrangements is that the un-encoded transmission to the memory cores increases power consumption, voltage droop, and SSO noise. Advantageously, some embodiments include technology to extend the DBI all the way to the memory cores, thereby significantly reducing one or more of power consumption, voltage droop, and SSO noise.

As speeds of HBM devices increase, the data on the DQ bus may be parallelized through the TSV path (e.g., 1-DQ:2-TSV in HBM2; 1-DQ:4-TSV in HBM3, and so on) to limit the core clock speed increase. Some embodiments may re-arrange the burstlength (BL) bits (e.g., BL0 - BL7) to extend the DBI encoding from the memory controller to the HBM device memory cores through the TSV signal path.

The heat generated in an HBM device may be directly proportional to its power consumption. Because the HBM device may be on the same package as a SoC device, the heat generated by the HBM device directly translates to the cooling solution. Device power in some HBM devices may be over 20 Watts. Furthermore, HBM device performance may be limited by the robustness of the power delivery solution. Significant package resources may be required to deliver the required power delivery performance, which may depend on the instantaneous current consumption. Some embodiments may advantageous reduce power consumption and/or reduce switching currents to alleviate the package power delivery constraints.

Approximately 40% of the total power consumption may be for data transmission though TSVs. Some embodiments may provide DBI technology to reduce the average toggling and to reduce average power consumption. For an 8-bit data per DBI encoding, the average cycle-to-cycle toggle count may be reduced by about 20% (e.g., advantageously providing about 1.6 Watt power savings on a 20 Watt HBM device. The transient current (ICC(t)) may be directly proportional to a number of lanes switching every cycle. Some embodiments may provide DBI technology to limit the count to half the bits/DBI, thereby reducing ICC(t) in the memory core region and making the power delivery more robust. Some embodiments may be independently applied for the path from a SoC memory controller and the SoC physical layer (PHY), and/or the path from the SoC PHY to the HBM device memory cores. In some embodiment, more advantages are realized by applying DBI technology from the memory controller to the HBM device memory cores.

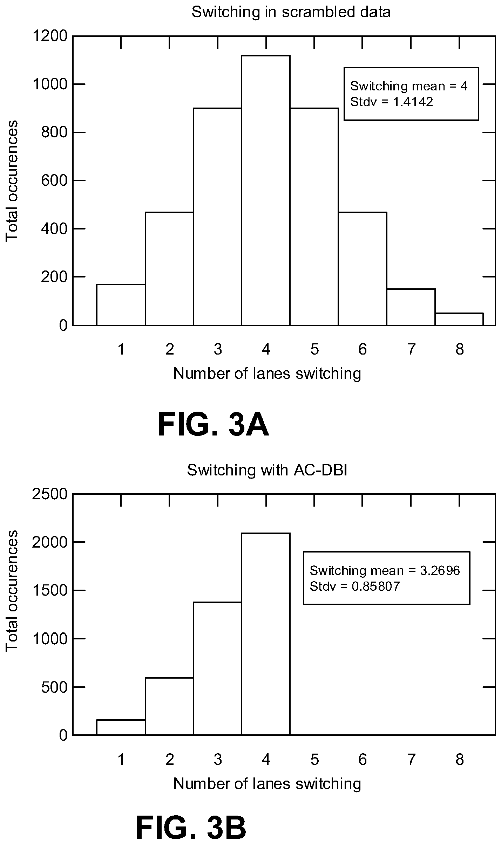

With reference to FIGs. 3A and 3B, example bar graphs show an impact of alternating current (AC)-DBI. An encoding of 8-bits/DBI is shown with a total run length of 2^12 bits. The graphs show histograms of the count of lanes switching from cycle-cycle. A scrambled data without AC-DBI averages to 4 lanes switching from cycle to cycle (e.g., see FIG. 3A). When AC-DBI is applied, the average goes down asymptotically to about 3.21 lanes (e.g., see FIG. 3B), including a DBI lane. Advantageously, applying DBI reduces average switching by about 20%.

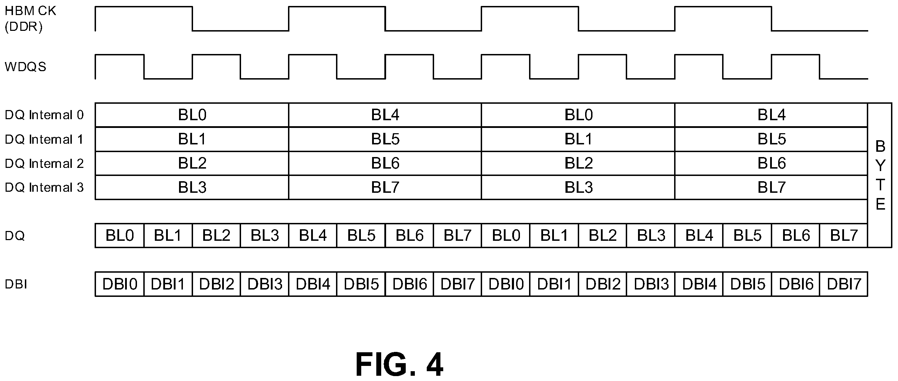

With reference to FIG. 4, an example sequential bit arrangement and timing diagram for a burst length of 8 is shown for a HBM device architecture having a 1:4 IO to internal bus interleaving ratio. The illustrated arrangement may reduce latency but precludes extending the same DBI encoding to an internal TSV path. For example, DBI1 bit encoded the switching activity between BL0 and BL1 but DQ internal 0 transmits BL0 followed by BL4.

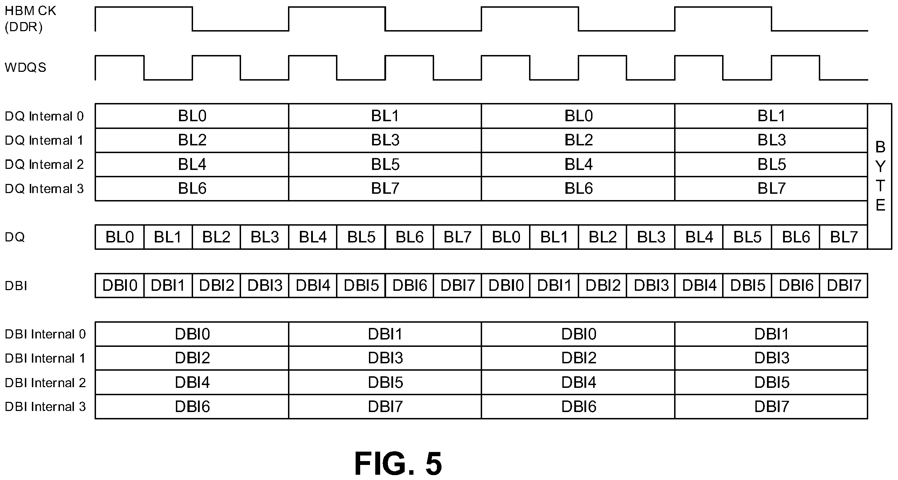

With reference to FIG. 5, an example non-sequential bit arrangement and timing diagram for a burst length of 8 is shown for a HBM device architecture having a 1:4 IO to internal bus interleaving ratio. By organizing the bits as shown and adding an internal DBI path, the same DBI encoding is advantageously extended from the memory controller through the SoC PHY and all the way to the memory cores (e.g., through the base logic die and along the TSV path). In some embodiments, the additional DBI internal path may add about 12% additional TSVs. In some embodiments, a two entry FIFO may be utilized to re-arrange the initial IO bit arrangement to the DBI bit arrangement.

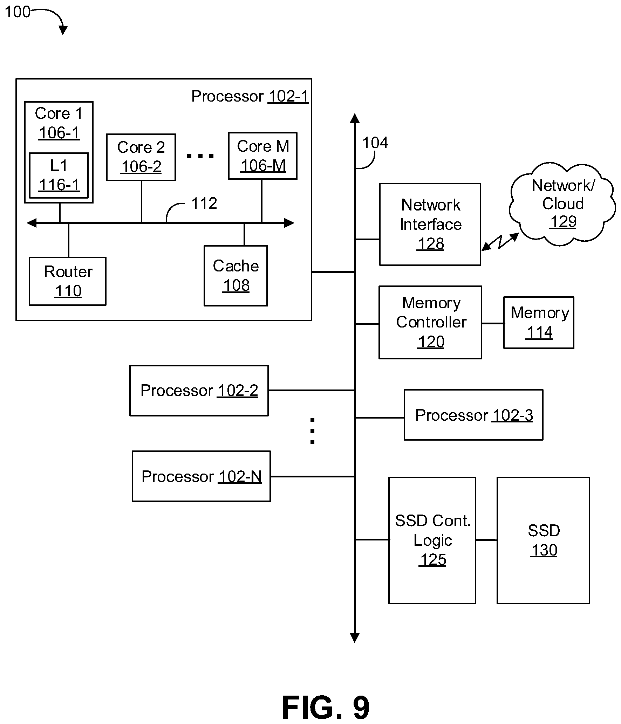

The HBM device includes a multi-rank system with the same channel distributed across different ranks. The memory controller or the DBI logic keeps track of the previous cycle for consecutive READs to different ranks. Because the TSVs may be connected to the channel for all ranks (e.g., see FIG. 9), the DBI logic in the inactive ranks keeps track of the data sent. Additional timing may be available between rank switches which will allow the device to precondition the bus and ensure proper DBI operation.

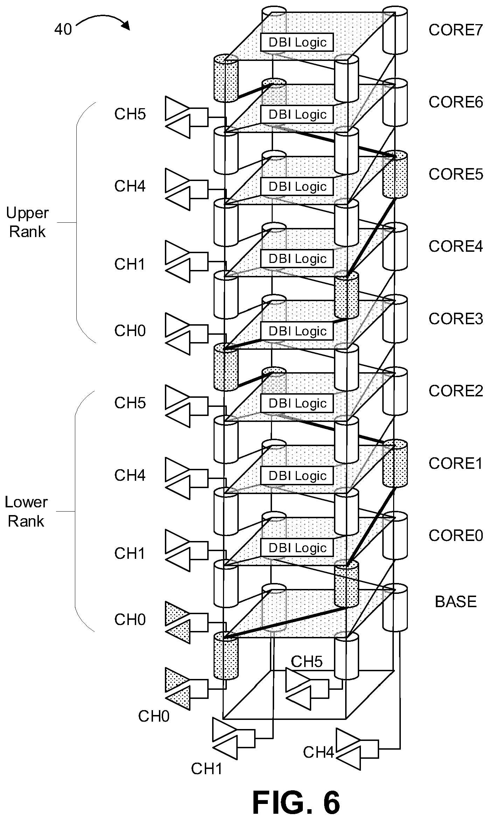

With reference to FIG. 6, an embodiment of a memory stack device 40 may include a base logic device and a stack of eight (8) memory devices CORE0 through CORE7, coupled as shown. Each of the memory devices includes DBI logic as described herein. Those skilled in the art will appreciate that the illustrated arrangement is one example of a suitable TSV arrangement. Any suitable number of memory cores together with any suitable TSV arrangement may be utilized in other embodiments, together with suitable DBI logic for each of the memory cores.

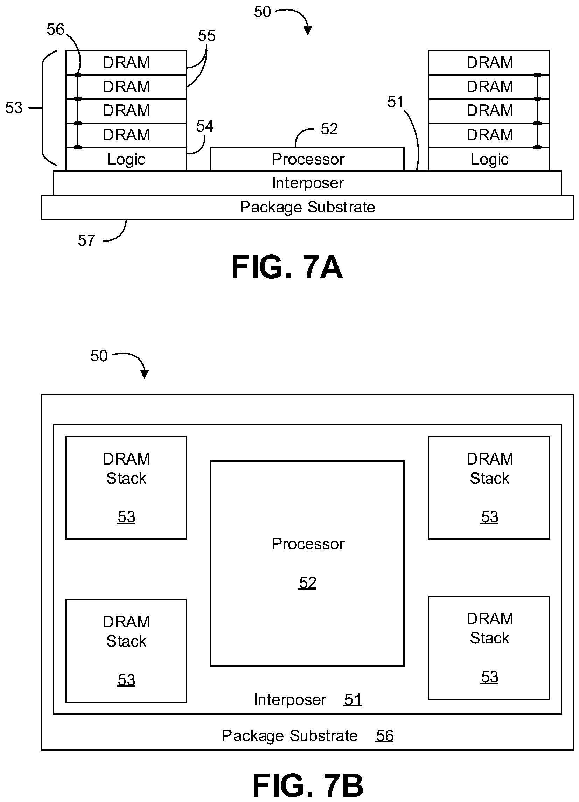

With reference to FIGs. 7A to 7B, an embodiment of an electronic apparatus 50 may include an interposer 51, a processor 52 coupled to the interposer 51, and at least one memory stack device 53 (e.g., a DRAM stack) coupled to the interposer 51 and communicatively coupled to the processor 52 through the interposer 51. The at least one memory stack device 53 may include a stack of dice including at least one logic die 54 and at least two WP memory dice 55 (e.g., DRAM). An inter-die connection for the memory dice 55 and/or logic die 54 may be made with through silicon vias (TSVs) 56, for example. The at least two memory dice 55 each comprise DBI logic (e.g., as described herein). In some embodiments, the apparatus 50 may further include a package substrate 57 coupled to the interposer 51. For example, the package substrate 57 may include a SoC package or a printed circuit board such as graphics board, a HPC board, etc.

The DBI logic integrated on each memory dice 55 is configured to encode and decode a data signal on a signal path through the TSVs 56 in accordance with a data bus inversion of the data signal. For example, the DBI logic may be configured to extend the data bus inversion from the processor 52 to the at least two memory dice 55 (e.g., or from the processor 52 to the SOC PHY, or from the SOC PHY to the memory dice 55). In some embodiments, the DBI logic may be further configured to arrange bits of the data signal non-sequentially among the TSVs 56 in accordance with the data bus inversion of the data signal. For example, the DBI logic may include a multi-entry FIFO buffer to arrange the bits of the data signal non-sequentially. The at least one memory stack device 53 is associated with a plurality of ranks, and the DBI logic is configured to keep track of previous read cycles for consecutive read operations to different ranks of the plurality of ranks, and to keep track of data sent from an inactive rank of the plurality of ranks.

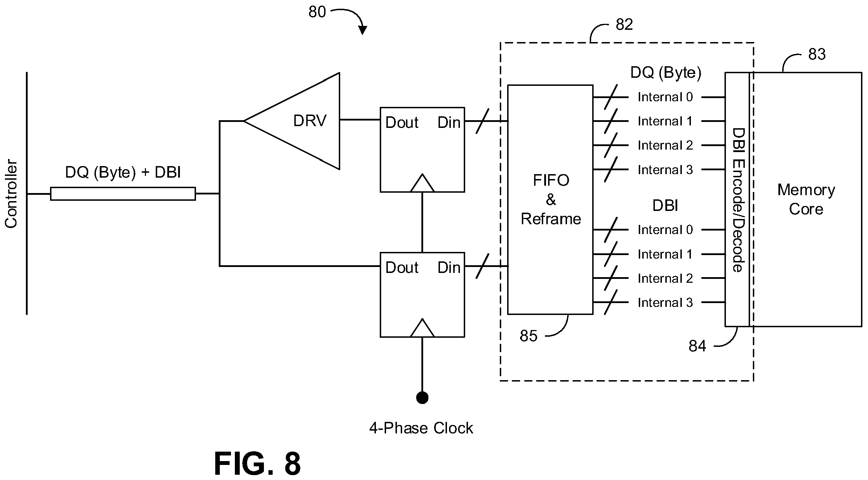

With reference to FIG. 8, an embodiment of a memory apparatus 80 includes DBI logic 82 at least partially integrated with a memory core 83. The DBI logic 82 may include DBI encode/decode logic 84 and a two-entry FIFO 85 to non-sequentially arrange bits among an internal DBI signal path. For example, the internal DBI signal path may be provided by TSVs in a memory stack device. The DBI logic 82 may extend data bus inversion from a controller all the way to the memory core 83.

During operation, a DBI encoded DQ byte with a DBI bit is sent over the interface between controller and the memory apparatus 80. During WRITES, the memory apparatus 80 may receive the data using a divided four phase clock. The FIFO 85 is configured to receive two cycles of data and reframe it as shown. The DBI bit is also deserialized along with DQ and sent over the internal bus (TSV) to the memory core 83 where the DBI decoding is performed by the DBI encode/decode logic 84. The opposite happens during READs. Data is DBI encoded in the memory core by the DBI encode/decode logic 84 and sent over the internal bus. The data is reframed in the FIFO 85 and serialized to be sent over the interface between the memory apparatus 80 and the controller.

The technology discussed herein may be provided in various computing systems (e.g., including a non-mobile computing device such as a desktop, workstation, server, rack system, etc., a mobile computing device such as a smartphone, tablet, Ultra-Mobile Personal Computer (UMPC), laptop computer, ULTRABOOK computing device, smart watch, smart glasses, smart bracelet, etc., and/or a client/edge device such as an Internet-of-Things (IoT) device (e.g., a sensor, a camera, etc.)).

Turning now to FIG. 9, an embodiment of a computing system 100 may include one or more processors 102-1 through 102-N (generally referred to herein as "processors 102" or "processor 102"). The processors 102 may communicate via an interconnection or bus 104. Each processor 102 may include various components some of which are only discussed with reference to processor 102-1 for clarity. Accordingly, each of the remaining processors 102-2 through 102-N may include the same or similar components discussed with reference to the processor 102-1.

In some embodiments, the processor 102-1 may include one or more processor cores 106-1 through 106-M (referred to herein as "cores 106," or more generally as "core 106"), a cache 108 (which may be a shared cache or a private cache in various embodiments), and/or a router 110. The processor cores 106 may be implemented on a single integrated circuit (IC) chip. Moreover, the chip may include one or more shared and/or private caches (such as cache 108), buses or interconnections (such as a bus or interconnection 112), memory controllers, or other components.

In some embodiments, the router 110 may be used to communicate between various components of the processor 102-1 and/or system 100. Moreover, the processor 102-1 may include more than one router 110. Furthermore, the multitude of routers 110 may be in communication to enable data routing between various components inside or outside of the processor 102-1.

The cache 108 may store data (e.g., including instructions) that is utilized by one or more components of the processor 102-1, such as the cores 106. For example, the cache 108 may locally cache data stored in a memory 114 for faster access by the components of the processor 102. As shown in FIG. 9, the memory 114 may be in communication with the processors 102 via the interconnection 104. In some embodiments, the cache 108 (that may be shared) may have various levels, for example, the cache 108 may be a mid-level cache and/or a last-level cache (LLC). Also, each of the cores 106 may include a level 1 (L1) cache (116-1) (generally referred to herein as "L1 cache 116"). Various components of the processor 102-1 may communicate with the cache 108 directly, through a bus (e.g., the bus 112), and/or a memory controller or hub.

As shown in FIG. 9, memory 114 may be coupled to other components of system 100 through a memory controller 120. Memory 114 may include volatile memory and may be interchangeably referred to as main memory. Even though the memory controller 120 is shown to be coupled between the interconnection 104 and the memory 114, the memory controller 120 may be located elsewhere in system 100. For example, memory controller 120 or portions of it may be provided within one of the processors 102 in some embodiments.

The system 100 may communicate with other devices/systems/networks via a network interface 128 (e.g., which is in communication with a computer network and/or the cloud 129 via a wired or wireless interface). For example, the network interface 128 may include an antenna (not shown) to wirelessly (e.g., via an Institute of Electrical and Electronics Engineers (IEEE) 802.11 interface (including IEEE 802.11a/b/g/n/ac, etc.), cellular interface, 3G, 4G, LTE, BLUETOOTH, etc.) communicate with the network/cloud 129.

System 100 may also include a storage device such as a SSD device 130 coupled to the interconnect 104 via SSD controller logic 125. Hence, logic 125 may control access by various components of system 100 to the SSD device 130. Furthermore, even though logic 125 is shown to be directly coupled to the interconnection 104 in FIG. 9, logic 125 can alternatively communicate via a storage bus/interconnect (such as the SATA (Serial Advanced Technology Attachment) bus, Peripheral Component Interconnect (PCI) (or PCI EXPRESS (PCIe) interface), NVM EXPRESS (NVMe), etc.) with one or more other components of system 100 (for example where the storage bus is coupled to interconnect 104 via some other logic like a bus bridge, chipset, etc.) Additionally, logic 125 may be incorporated into memory controller logic or provided on a same integrated circuit (IC) device in various embodiments (e.g., on the same circuit board device as the SSD device 130 or in the same enclosure as the SSD device 130).

Furthermore, logic 125 and/or SSD device 130 may be coupled to one or more sensors (not shown) to receive information (e.g., in the form of one or more bits or signals) to indicate the status of or values detected by the one or more sensors. These sensor(s) may be provided proximate to components of system 100 (or other computing systems discussed herein), including the cores 106, interconnections 104 or 112, components outside of the processor 102, SSD device 130, SSD bus, SATA bus, logic 125, etc., to sense variations in various factors affecting power/thermal behavior of the system/platform, such as temperature, operating frequency, operating voltage, power consumption, and/or inter-core communication activity, etc.

Advantageously, the memory 114, or other memory communicatively coupled to the processors 102, may include technology to implement one or more aspects of the apparatus 10 (FIG. 1), the apparatus 20 (FIG. 2), the memory stack device 40 (FIG. 6), the apparatus 50 (FIGs. 7A and 7B), the apparatus 80 (FIG. 8), and/or any of the features discussed herein. For example, the memory 114 may include an embodiment of a HBM compatible DRAM device with an internal DBI path with one or more of the features discussed herein (e.g., memory cores with DBI logic, extra TSVs for the internal DBI path, etc.).

The term "coupled" may be used herein to refer to any type of relationship, direct or indirect, between the components in question, and may apply to electrical, mechanical, fluid, optical, electromagnetic, electromechanical or other connections. In addition, the terms "first", "second", etc. may be used herein only to facilitate discussion, and carry no particular temporal or chronological significance unless otherwise indicated.

As used in this application and in the claims, a list of items joined by the term "one or more of" may mean any combination of the listed terms. For example, the phrase "one or more of A, B, and C" and the phrase "one or more of A, B, or C" both may mean A; B; C; A and B; A and C; B and C; or A, B and C. Various components of the systems described herein may be implemented in software, firmware, and/or hardware and/or any combination thereof. For example, various components of the systems or devices discussed herein may be provided, at least in part, by hardware of a computing SoC such as may be found in a computing system such as, for example, a smart phone. Those skilled in the art may recognize that systems described herein may include additional components that have not been depicted in the corresponding

figures. For example, the systems discussed herein may include additional components such as bit stream multiplexer or de-multiplexer modules and the like that have not been depicted in the interest of clarity.

In addition, any one or more of the operations discussed herein may be undertaken in response to instructions provided by one or more computer program products. Such program products may include signal bearing media providing instructions that, when executed by, for example, a processor, may provide the functionality described herein. The computer program products may be provided in any form of one or more machine-readable media. Thus, for example, a processor including one or more graphics processing unit(s) or processor core(s) may undertake one or more of the blocks of the example processes herein in response to program code and/or instructions or instruction sets conveyed to the processor by one or more machine-readable media. In general, a machine-readable medium may convey software in the form of program code and/or instructions or instruction sets that may cause any of the devices and/or systems described herein to implement at least portions of the operations discussed herein and/or any portions the devices, systems, or any module or component as discussed herein.

As used in any implementation described herein, the term "module" refers to any combination of software logic, firmware logic, hardware logic, and/or circuitry configured to provide the functionality described herein. The software may be embodied as a software package, code and/or instruction set or instructions, and "hardware", as used in any implementation described herein, may include, for example, singly or in any combination, hardwired circuitry, programmable circuitry, state machine circuitry, fixed function circuitry, execution unit circuitry, and/or firmware that stores instructions executed by programmable circuitry. The modules may, collectively or individually, be embodied as circuitry that forms part of a larger system, for example, an integrated circuit (IC), system on-chip (SoC), and so forth.

Various embodiments may be implemented using hardware elements, software elements, or a combination of both. Examples of hardware elements may include processors, microprocessors, circuits, circuit elements (e.g., transistors, resistors, capacitors, inductors, and so forth), integrated circuits, application specific integrated circuits (ASIC), programmable logic devices (PLD), digital signal processors (DSP), field programmable gate array (FPGA), logic gates, registers, semiconductor device, chips, microchips, chip sets, and so forth. Examples of software may include software components, programs, applications, computer programs, application programs, system programs, machine programs, operating system software, middleware, firmware, software modules, routines, subroutines, functions, methods, procedures, software interfaces, application program interfaces (API), instruction sets, computing code, computer code, code segments, computer code segments, words, values, symbols, or any combination thereof. Determining whether an embodiment is implemented using hardware elements and/or software elements may vary in accordance with any number of factors, such as desired computational rate, power levels, heat tolerances, processing cycle budget, input data rates, output data rates, memory resources, data bus speeds and other design or performance constraints.

One or more aspects of at least one embodiment may be implemented by representative instructions stored on a machine-readable medium which represents various logic within the processor, which when read by a machine causes the machine to fabricate logic to perform the techniques described herein. Such representations, known as IP cores may be stored on a tangible, machine readable medium and supplied to various customers or manufacturing facilities to load into the fabrication machines that actually make the logic or processor.

## Claims

1. A memory apparatus (10), comprising:
a memory core (11) of a memory circuit (23), the memory core (11) being associated with a plurality of ranks;
a plurality of through-silicon vias, TSVs, (12); and
data bus inversion logic (13) coupled between the memory core (11) and the TSVs (12), wherein the data bus inversion logic (13) is configured to:
encode and decode a data signal on a signal path through the TSVs (12) in accordance with a data bus inversion of the data signal;
keep track of previous read cycles for consecutive read operations to different ranks of the plurality of ranks; and
keep track of data sent from an inactive rank of the plurality of ranks.

2. The memory apparatus (10) of claim 1, wherein the data bus inversion logic (13) is further configured to:
extend the data bus inversion of the data signal from a memory controller to a physical layer of the memory apparatus (10).

3. An electronic apparatus (20), comprising:
a silicon substrate (21); and
the memory apparatus (10) of claim 1, wherein the plurality of vias (22) is disposed completely through the silicon substrate (21); and
wherein the memory core (11) is included in a memory circuit (23) coupled to the silicon substrate (21) and the plurality of vias (22).

4. The electronic apparatus (20) of claim 3, wherein the logic (24) is further configured to:
extend the data bus inversion of the data signal from a memory controller to a physical layer of the memory circuit (23).

5. The electronic apparatus (20) of any of claims 3 to 4, wherein the logic (24) is further configured to:
extend the data bus inversion from a memory controller to a memory core of the memory circuit (23).

6. The electronic apparatus (20) of any of claims 3 to 4, wherein the logic (24) includes a encode/decode logic (84) and a two-entry first-in-first-out buffer (85) and is further configured to: arrange, by the encode/decode logic (84) and the two-entry first-in-first-out buffer (85), bits of the data signal non-sequentially among the plurality of vias (22) in accordance with the data bus inversion of the data signal.

7. The electronic apparatus (20) of claim 6, wherein the logic (24) comprises a multi-entry first-in-first-out buffer to arrange the bits of the data signal non-sequentially.

8. An electronic apparatus (50), comprising:
an interposer (51);
a processor (52) coupled to the interposer (51); and
at least one memory stack device (53) coupled to the interposer (51) and communicatively coupled to the processor (52) through the interposer (51), the at least one memory stack device (53) including a stack of dice including at least one logic die (54) and at least two memory dice (55) comprising the memory apparatus of claim 1, wherein the at least one logic die (54) and the at least two memory dice (55) are coupled to each other by the plurality of through-silicon-vias, TSVs, (56).

9. The electronic apparatus (50) of claim 8, wherein the data bus inversion logic (13) is further configured to:
extend the data bus inversion from the processor (52) to the at least two memory dice (55).

10. The electronic apparatus (50) of any of claims 8 to 9, wherein the data bus inversion logic (13) includes a multi-entry first-in-first-out buffer and is further configured to:
arrange, by the multi-entry first-in-first-out buffer, bits of the data signal non-sequentially among the TSVs (56) in accordance with the data bus inversion of the data signal.

11. The electronic apparatus (50) of claim 10, wherein the data bus inversion logic (13) comprises:
a multi-entry first-in-first-out buffer to arrange the bits of the data signal non-sequentially.

## Patentansprüche

1. Speichervorrichtung (10), umfassend:
einen Speicherkern (11) einer Speicherschaltung (23), wobei der Speicherkern (11) mit einer Mehrzahl von Rängen assoziiert ist;
eine Mehrzahl von durch das Silizium hindurchgehenden Durchkontaktierungen, TSVs, (12); und
Datenbusinversionslogik (13), die zwischen den Speicherkern (11) und die TSVs (12) gekoppelt ist, wobei die Datenbusinversionslogik (13) konfiguriert ist zum:
Codieren und Decodieren eines Datensignals auf einem Signalpfad durch die TSVs (12) gemäß einer Datenbusinversion des Datensignals;
Verfolgen von früheren Lesezyklen für nachfolgende Leseoperationen für verschiedene Ränge der Mehrzahl von Rängen; und
Verfolgen von Daten, die von einem inaktiven Rang der Mehrzahl von Rängen gesendet werden.

2. Speichervorrichtung (10) nach Anspruch 1, wobei die Datenbusinversionslogik (13) ferner konfiguriert ist zum:
Erweitern der Datenbusinversion des Datensignals von einer Speichersteuerung auf eine physikalische Schicht der Speichervorrichtung (10).

3. Elektronische Vorrichtung (20), umfassend:
ein Siliziumsubstrat (21); und
die Speichervorrichtung (10) nach Anspruch 1, wobei die Mehrzahl von Durchkontaktierungen (22) vollständig durch das Siliziumsubstrat (21) hindurch angeordnet ist; und
wobei der Speicherkern (11) in einer Speicherschaltung (23) umfasst ist, die mit dem Siliziumsubstrat (21) und der Mehrzahl von Durchkontaktierungen (22) gekoppelt ist.

4. Elektronische Vorrichtung (20) nach Anspruch 3, wobei die Logik (24) ferner konfiguriert ist zum:
Erweitern der Datenbusinversion des Datensignals von einer Speichersteuerung auf eine physikalische Schicht der Steuerschaltung (23).

5. Elektronische Vorrichtung (20) nach einem der Ansprüche 3 bis 4, wobei die Logik (24) ferner konfiguriert ist zum:
Erweitern der Datenbusinversion des Datensignals von einer Speichersteuerung auf einen Speicherkern der Speicherschaltung (23).

6. Elektronische Vorrichtung (20) nach einem der Ansprüche 3 bis 4, wobei die Logik (24) Codier-/Decodierlogik (84) und einen Zuerst-rein-zuerst-raus-Puffer (85) mit zwei Eingängen umfasst und ferner konfiguriert ist zum: nicht-sequenziellen Anordnen von Bits des Datensignals durch die Codier-/Decodierlogik (84) und den Zuerst-rein-zuerst-raus-Puffer (85) mit zwei Eingängen unter der Mehrzahl von Durchkontaktierungen (22) gemäß der Datenbuskonversion des Datensignals.

7. Elektronische Vorrichtung (20) nach Anspruch 6, wobei die Logik einen Zuerst-rein-zuerst-raus-Puffer mit mehreren Eingängen zum nicht-sequenziellen Anordnen der Bits des Datensignals umfasst.

8. Elektronische Vorrichtung (50), umfassend:
einen Interposer (51);
einen Prozessor (52), der mit dem Interposer (51) gekoppelt ist; und
mindestens ein Speicherstapelbauelement (53), das mit dem Interposer (51) gekoppelt und über den Interposer (51) kommunikativ mit dem Prozessor (52) gekoppelt ist, wobei das mindestens eine Speicherstapelbauelement (53) einen Chipstapel umfasst, der mindestens einen Logikchip (54) und mindestens zwei Speicherchips (55) umfasst, die die Speichervorrichtung nach Anspruch 1 umfassen, wobei der mindestens eine Logikchip (54) und die mindestens zwei Speicherchips (55) durch die Mehrzahl von durch das Silizium hindurchgehenden Durchkontaktierungen, TSVs, (56) miteinander gekoppelt sind.

9. Elektronische Vorrichtung (50) nach Anspruch 8, wobei die Datenbusinversionslogik (13) ferner konfiguriert ist zum:
Erweitern der Datenbusinversion vom Prozessor (52) auf die mindestens zwei Speicherchips (55).

10. Elektronische Vorrichtung (50) nach einem der Ansprüche 8 bis 9, wobei die Datenbusinversionslogik (13) einen Zuerst-rein-zuerst-raus-Puffer mit mehreren Eingängen umfasst und ferner konfiguriert ist zum:
nicht-sequenziellen Anordnen von Bits des Datensignals durch den Zuerst-rein-zuerst-raus-Puffer mit mehreren Eingängen unter den TSVs (56) gemäß der Datenbuskonversion des Datensignals.

11. Elektronische Vorrichtung (50) nach Anspruch 10, wobei die Datenbusinversionslogik (13) umfasst:
einen Zuerst-rein-zuerst-raus-Puffer mit mehreren Eingängen zum nicht-sequenziellen Anordnen der Bits des Datensignals.

## Revendications

1. Appareil de mémoire (10), comprenant :
un coeur de mémoire (11) d'un circuit de mémoire (23), le coeur de mémoire (11) étant associé à une pluralité de rangs ;
une pluralité d'interconnexions verticales, TSV (12) ; et
une logique d'inversion de bus de données (13) couplée entre le coeur de mémoire (11) et les TSV (12), la logique d'inversion de bus de données (13) étant configurée pour :
coder et décoder un signal de données sur un chemin de signal à travers les TSV (12) en fonction d'une inversion de bus de données du signal de données ;
garder une trace de cycles de lecture antérieurs pour des opérations de lecture ultérieures sur différents rangs de la pluralité de rangs ; et
garder une trace de données envoyées depuis un rang inactif de la pluralité de rangs.

2. Appareil de mémoire (10) de la revendication 1, dans lequel la logique d'inversion de bus de données (13) est en outre configurée pour :
étendre l'inversion de bus de données du signal de données depuis un contrôleur de mémoire jusqu'à une couche physique de l'appareil de mémoire (10).

3. Appareil électronique (20), comprenant :
un substrat de silicium (21) ; et
l'appareil de mémoire (10) de la revendication 1, dans lequel la pluralité d'interconnexions verticales (22) est disposée entièrement à travers le substrat de silicium (21) ; et
dans lequel le coeur de mémoire (11) est inclus dans un circuit de mémoire (23) couplé au substrat de silicium (21) et à la pluralité d'interconnexions verticales (22).

4. Appareil électronique (20) de la revendication 3, dans lequel la logique (24) est en outre configurée pour :
étendre l'inversion de bus de données du signal de données depuis un contrôleur de mémoire jusqu'à une couche physique du circuit de mémoire (23).

5. Appareil électronique (20) de l'une quelconque des revendications 3 à 4, dans lequel la logique (24) est en outre configurée pour :
étendre l'inversion de bus de données depuis un contrôleur de mémoire jusqu'à un coeur de mémoire du circuit de mémoire (23).

6. Appareil électronique (20) de l'une quelconque des revendications 3 à 4, dans lequel la logique (24) inclut une logique de codage/décodage (84) et un tampon premier entré premier sorti à deux entrées (85) et est en outre configurée pour : agencer, par la logique de codage/décodage (84) et le tampon premier entré premier sorti à deux entrées (85), des bits du signal de données de façon non séquentielle parmi la pluralité d'interconnexions verticales (22) en fonction de l'inversion de bus de données du signal de données.

7. Appareil électronique (20) de la revendication 6, dans lequel la logique (24) comprend un tampon premier entré premier sorti à multiples entrées pour agencer les bits du signal de données de façon non séquentielle.

8. Appareil électronique (50), comprenant :
un interposeur (51) ;
un processeur (52) couplé à l'interposeur (51) ; et
au moins un dispositif d'empilement de mémoire (53) couplé à l'interposeur (51) et couplé de façon communicante au processeur (52) par le biais de l'interposeur (51), l'au moins un dispositif d'empilement de mémoire (53) comportant un empilement de puces incluant au moins une puce logique (54) et au moins deux puces de mémoire (55) comprenant l'appareil de mémoire de la revendication 1, dans lequel l'au moins une puce logique (54) et les au moins deux puces de mémoire (55) sont couplées les unes aux autres par la pluralité d'interconnexions verticales, TSV (56).

9. Appareil électronique (50) de la revendication 8, dans lequel la logique d'inversion de bus de données (13) est en outre configurée pour :
étendre l'inversion de bus de données depuis le processeur (52) jusqu'aux au moins deux puces de mémoire (55).

10. Appareil électronique (50) de l'une quelconque des revendications 8 à 9, dans lequel la logique d'inversion de bus de données (13) comporte un tampon premier entré premier sorti à multiples entrées et est en outre configurée pour :
agencer, par le tampon premier entré premier sorti à multiples entrées, des bits du signal de données de façon non séquentielle parmi les TSV (56) en fonction de l'inversion de bus de données du signal de données.

11. Appareil électronique (50) de la revendication 10, dans lequel la logique d'inversion de bus de données (13) comprend :
un tampon premier entré premier sorti à multiples entrées pour agencer les bits du signal de données de façon non séquentielle.
